# EUROPÄISCHE PATENTSCHRIFT

(11) **EP 3 012 466 B1**
(45) Veröffentlichungstag und Bekanntmachung des Hinweises auf die Patenterteilung: **29.08.2018**
(21) Anmeldenummer: 15195515.0
(22) Anmeldetag: 21.05.2014
(51) Int. Cl.: F16B 5/12, F16B 19/10, F16B 2/24, F16B 21/08

(54) **BEFESTIGUNGSELEMENT ZUR FESTLEGUNG ZWEIER BAUTEILE ANEINANDER**
ANCHORING ELEMENT FOR FASTENING TWO COMPONENTS TO ONE ANOTHER
ÉLEMENT DE FIXATION DE DEUX COMPOSANTS ENTRE EUX

(30) Priorität: 15.07.2013 DE 202013006326 U; 15.07.2013 DE 202013006325 U; 24.08.2013 DE 202013007589 U; 17.02.2014 DE 202014001330 U
(43) Veröffentlichungstag der Anmeldung: 27.04.2016
(62) Teilanmeldung aus: 14744449.1
(73) Patentinhaber: BJB GmbH & Co. KG, 59755 Arnsberg (DE)
(72) Erfinder: Baumeister, Olaf, 59846 Sundern (DE); Beleke, Herbert, 59821 Arnsberg (DE)
(74) Vertreter: Ostriga Sonnet Wirths & Vorwerk

(56) Entgegenhaltungen:
- DE-U1-202012 002 831
- FR-A- 789 664
- FR-A- 1 417 603
- US-A- 2 238 238
- US-A- 2 245 375
- US-A- 2 265 957

## Beschreibung

Die Erfindung betrifft Befestigungselement zur Festlegung eines ersten Bauteils, wie mit LEDs bestückte Leiterplatte, welches eine Durchbrechung aufweist, mit einem zweiten Bauteil, wie Leuchtenbauteil, welches eine Ausnehmung, wie Sackloch oder Durchbrechung, aufweist,
- mit einem Schaft, der wenigstens ein federrückstellelastisches Halteteil aufweist, das Befestigungselement am zweiten Bauteil verankert,
- mit einem Schaftkopf, der gegenüber dem Schaftdurchmesser einen erweiterten Kopfdurchmesser aufweist, wobei
- der Schaftkopf an einem Ende des Schaftes angeordnet ist und
- mit einem Spannelement, welches das erste Bauteil gegen das zweite Bauteil unter einer definierten Anpresskraft verspannt.

Derartige Befestigungselemente sind im Bereich der Leuchtenindustrie bislang nicht bekannt. Ähnliche Befestigungselemente existieren jedoch im Bereich der Automobiltechnik. Hierzu wird beispielsweise auf die WO2005/071273 A1 verwiesen. Sie dienen dort in aller Regel der Befestigung von Innenverkleidungsteilen an der Fahrzeugkarosserie. Hierzu weist das Innenverkleidungsteil eine Durchbrechung, beispielsweise eine Bohrung auf, die das Innenverkleidungsteil in voller Stärke durchsetzt. Auf Seiten der Karosserie ist in aller Regel ebenfalls ein Blechteil vorgesehen, welches eine Bohrung aufweist. Die Durchbrechung des Innenverkleidungsteils und die Bohrung der Karosserie werden in Deckung gebracht. Sodann wird das Befestigungselement, häufig auch als Spreizniet bezeichnet, durch die Durchbrechung hindurch in die Bohrung eingesetzt. Die Festlegung des Spreizniets in der karosserieseitigen Bohrung kann reibschlüssig erfolgen, beispielsweise durch Kunststofflamellen, die am Schaft des Befestigungselementes ausbildet sind. Auch rastende Verbindungen sind möglich, indem Rasthaken des Befestigungselementes in Rastausnehmungen eingreifen.

Im Bereich der Leuchtenindustrie werden Leuchten zunehmend mit LEDs als Lichtquellen gefertigt. Es etablieren sich derzeit bestimmte LED-Typen.
So ist es üblich, LEDs auf Platinen aufzubringen und diese als Zulieferbauteile der Leuchtenindustrie zur weiteren Verwendung zur Verfügung zu stellen. Zwar variieren Art, Material und Form der Platinen ebenso wie die auf ihnen aufgebrachten LEDs in Anzahl und Verteilung, jedoch ist eine Befestigung dieser Platinen am Leuchtenbauteil in jedem Fall erforderlich. Ein gleichmäßiger flächiger Andruck der Platine an dem Leuchtbauteil gewährleistet dabei eine optimale Wärmeableitung von den LEDs.
Im Stand der Technik sind mit DE 10 2008 005 823 B4 oder DE 10 2012 003 520 B4 Anschlusselemente für derartige Platinen bekannt geworden. Diese vereinen die Platinenbefestigung mit der Möglichkeit der Spannungsversorgung der auf der Platine angeordneten LEDs. Das Dokument FR 789 664 A zeigt ein weiteres Befestigungselement nach dem Stand der Technik. Auch wenn diese Anschlusselemente in ihrer Vereinigung von Befestigung und Spannungsversorgung in vielen Fällen vorteilhaft sind, so bedarf es aufgrund veränderter Platinengestaltungen und anderer Fertigungsverfahren für Leuchten Befestigungsmittel, die in einer weitestgehend automatisierten Fertigung einsetzbar sind. Notwendig ist es darüber hinaus, dass diese die Platine der LED unter einem definierten Anpressdruck auf dem Leuchtenbauteil halten, um einen guten Wärmeübergang zu gewährleisten.

Gelöst wird diese Aufgabe von einem Befestigungsmittel mit den Merkmalen des Anspruchs 1. Ein Vorteil der Erfindung liegt darin, dass mit dem beschriebenen Befestigungselement die Möglichkeit besteht, eine Platine an einem Leuchtenbauteil durch einfaches Einschieben des Schaftes durch die Durchbrechung der Leiterplatte und hinein in die Ausnehmung des Leuchtenbauteils sicher zu befestigen. Dabei ist das Befestigungselement in bevorzugter Ausgestaltung aus Metall gefertigt und dabei durch Verformung eines Stanzteils gebildet. Auf diese Weise ist eine hohe Materialstabilität bei den gegenüber dem heterogenen Stand der Technik der Automobiltechnik sehr kleinen Befestigungselementen gewährleistet. Die hier vorgeschlagenen Befestigungselemente weisen in der Regel einen Schaftkopf von nicht mehr als 6 mm Durchmesser und eine Schaftlänge von nicht mehr als 7 mm bei einem Durchmesser von maximal 3 mm auf.
Der wesentliche Vorteil der Erfindung liegt darin, dass der Schaftkopf selbst das Spannelement ausbildet, in dem er einen Spannschenkel aufweist. Die Spannfunktion, welche eine definierte Anlage der zwei Bauteile, namentlich der LED-Platine und des Leuchtenbauteils aneinander gewährleistet, übernimmt somit der Spannkopf. Zusätzliche Bauteile, die die Herstellung und Montage aufwendig gestalten können, entfallen.
Insbesondere ist es auf diese Art und Weise möglich, dass das Befestigungselement durch Umformen eines aus einem Blech gebildeten Stanzlings erhalten ist, was eine effiziente Fertigung ermöglicht. Bevorzugt ist vorgesehen, dass der Spannschenkel als Teil des Schaftkopfes, ausgehend von einer Schaftlängsachse, zur Oberfläche des ersten Bauteils hin abfallend geneigt ist, wobei beim Einsetzen des Befestigungselementes in die Ausnehmung dem Spannschenkel durch Auflaufen auf die Oberfläche des ersten Bauteils eine die Federrückstellkraft aufbauende Bewegung aufgezwungen wird. Die Flügel, welche den Schaftkopf bilden, können als Spannschenkel ausgebildet sein und somit eine Doppelfunktion übernehmen. Einerseits halten sie das Befestigungselement auf dem ersten Bauteil, andererseits sorgen sie für das Aufbringen der Spannkraft zum Verspannen der beiden Bauteile gegeneinander.

Ferner ist in einer konkreten Ausführungsform vorgesehen, dass die Flügel durch einen Einschnitt entlang der schaftlängsaxialen Umformlinie und Umformen der so entstandenen Kopfenden der Schenkel in eine zur Auflage auf dem ersten Bauteil geeignete Stellung, insbesondere in eine zum ersten Bauteil geneigte Stellung, erhalten sind. Erfindungsgemäß ist eine Ausführungsform, welche sich dadurch kennzeichnet, dass die Einschnitte Schenkelabschnitte im Bereich des Schaftes voneinander trennen und die Schenkelabschnitte federrückstellelastisch zur Schaftlängsachse hin auslenkbar sind. Der wesentliche Vorteil der federrückstellelastisch ausgebildeten Schenkelabschnitte des Schaftes ist darin zu sehen, dass diese die Spannfunktion des Schaftkopfes zusätzlich unterstützen. Beim Eintauchen des Befestigungselementes durch die Durchbrechung des ersten Bauteils in die Ausnehmung des zweiten Bauteils laufen also zunächst die Spannschenkel des Schaftkopfes auf die Oberfläche des ersten Bauteiles auf. Sind diese gemäß der vorbeschriebenen Ausführungsform von der Schaftlängsachse ausgehend zur Oberfläche des ersten Bauteils geneigt, werden sie unter Aufbau einer Federrückstellkraft entgegen der Einsetzrichtung X ausgelenkt und bringen so bereits eine gewisse Spannkraft auf. Darüber hinaus führt eine Verlagerung federrückstellelastischen Schenkelabschnitt des Schaftes in Richtung Schaftlängsachse unter Aufbau einer weiteren Federrückstellkraft zu einer verstärkten Spannkraft, die auf die aneinander zu befestigenden Bauteile wirkt.

Es ist bevorzugt vorgesehen, dass das freie Ende des ersten, längeren Schenkels durch Umformung wenigstens quer zu, bevorzugt jedoch gegen eine Einsetzrichtung x des Schaftes gerichtet ist.

Ferner ist bevorzugt vorgesehen, dass das freie, dem Schaftkopf abgewandte Ende des zweiten, kürzeren Schenkels eine Anschlagfläche für den Federarm des ersten Schenkels ausbildet. Der Schaft ist durch drei Schenkel gebildet, die durch Umformung eines Bleches entlang zweier schaftlängsaxialen Umformlinien erhalten sind.

Der wesentliche Vorteil dieser Ausführungsform liegt darin, dass der Schaft auf diese Weise gegen Biege- und Knickkräfte stabilisiert wird.
Wenn die Schenkel in ihrer Länge differieren und das freie Ende des ersten, längeren Schenkels das Halteteil in Form eines Federarmes bildet, und ferner vorgesehen ist, dass das freie Ende des ersten, längeren Schenkels durch Umformung wenigstens quer zu, bevorzugt jedoch gegen eine Einsetzrichtung des Schaftes gerichtet ist, ist sichergestellt, dass das Halteelement in Form eines Federarmes sich leicht und rationell fertigen lässt. Durch die Anbindung des Federarmes am ersten Schenkel kann der Federarm eine Länge größer dem Sacklochdurchmesser erhalten, was sich auf die Federeigenschaften positiv auswirkt und eine plastische Verformung verhindert.
Das freie, dem Schaftkopf abgewandte Ende des zweiten, kürzeren Schenkels kann eine Anschlagfläche für den Federarm des ersten Schenkels ausbildet. Die Anschlagfläche ist dabei derart angeordnet, dass sie den federrückstellelastischen Federarm vor Erreichen einer die Federrückstellkraft übersteigenden und eine plastische Verformung hervorrufenden Lageänderung schützt. So wird sichergestellt, dass die Federrückstellkraft des Federarmes ausreichend ist, um das Befestigungselement in der leuchtenbauteilseitigen Ausnehmung sicher zu halten und so die Platine am Leuchtenbauteil zu befestigen.

Weitere Vorteile der Erfindung sowie ein besseres Verständnis derselben folgen aus der nachfolgenden Beschreibung eines Ausführungsbeispiels. Es zeigen:
- Fig. 1:: einen Stanzling zur Erstellung eines erfindungsgemäßen Befestigungselementes,
- Fig. 2:: das erfindungsgemäße Befestigungselement nach Verformung des Stanzlings,
- Fig. 3:: die Ansicht gemäß Fig. 2 in einer ersten Seitenansicht,
- Fig. 4:: die Ansicht gemäß Fig. 2 in einer zweiten Seitenansicht,
- Fig. 5:: eine Aufsicht auf das Befestigungselement gemäß Fig. 2,
- Fig. 6:: die Seitenansicht des Befestigungselementes in Einbausituation,
- Fig. 7:: ein Schnitt gemäß Schnittlinie A-A in Fig. 6,
- Fig. 8:: eine Aufsicht auf die Darstellung gemäß Fig. 6,
- Fig. 9:: eine Schnittdarstellung gemäß Schnittlinie B-B in Fig. 8,
- Fig. 10:: eine Explosionsdarstellung von Leuchtenbauteil, Platine und Befestigungselement nebst Montagewerkezeug,
- Fig. 11:: einen Vertikalschnitt zur Darstellung der Wirkung des Montagewerkzeuges,
- Fig. 12:: die Darstellung gemäß Fig. 10, jedoch mit Demontagewerkzeug,
- Fig. 13:: eine Darstellung zur Verdeutlichung des Demontagevorgangs.
- Fig. 14:: eine alternative Ausführungsform des erfindungsgemäßen Befestigungselementes in einer ersten Seitenansicht
- Fig. 15:: das Befestigungselement gemäß Fig. 14 in einer zweiten Seitenansicht
- Fig. 16:: das Befestigungselement in Schnittansicht gemäß Schnittlinie A-A in Fig. 14
- Fig. 17:: eine Aufsicht auf das Befestigungselement gemäß Fig. 14 in Montagesituation
- Fig. 18:: eine Schnittansicht gemäß Schnittlinie B-B in Fig. 17

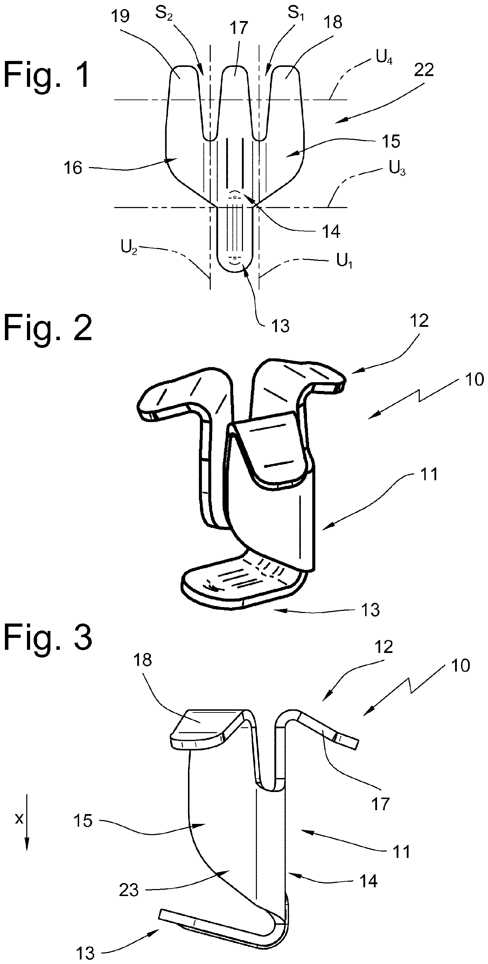

Ein erfindungsgemäßes Befestigungselement ist insgesamt mit der Bezugsziffer 10 versehen und in einer ersten Ausführungsform in den Fig. 1 bis 12 dargestellt.

Das Befestigungselement 10 weist zunächst einen Schaft 11 auf, einen Schaftkopf 12, welcher an einem Ende des Schaftes 11 angeordnet ist, sowie einen Federarm 13, der vom freien, dem Schaftkopf 12 gegenüberliegenden Ende des Schaftes 11 getragen wird.

Der Schaft 11 wird von drei untereinander einstückig-stoffschlüssig verbundenen Schenkeln gebildet, wobei der erste Schenkel die Bezugsziffer 14, der zweite Schenkel die Bezugsziffer 15 und der dritte Schenkel die Bezugsziffer 16 trägt. Der Schaftkopf 12 wird von drei Flügeln gebildet, wobei der erste Flügel die Bezugsziffer 17, der zweite Flügel die Bezugsziffer 18 und der dritte Flügel die Bezugsziffer 19 trägt. Der erste Flügel 17 ist Teil des ersten Schenkels 14, der zweite Flügel 18 ist Teil des zweiten Schenkels 15 und der dritte Flügel 19 ist Teil des dritten Schenkels 16. Die Flügel 17, 18, 19 sind dabei in etwa quer zu einer Schaftlängsachse L gerichtet und beim hier dargestellten Ausführungsbeispiel unter nahezu identischem Umfangswinkel versetzt angeordnet. Konkret sind die Flügel 17, 18, 19 ausgehend von der Schaftlängsachse L in Richtung der Oberfläche eines ersten Bauteils 24 hin geneigt ausgeführt und federrückstellelastisch ausgebildet. Sie sind dazu vorgesehen, auf dem ersten Bauteil 24 aufzuliegen.

Das erfindungsgemäße Befestigungselement 10 ist aus dem Stanzling 22 eines metallischen Blechs gebildet. Dieser ist in Fig. 1 dargestellt. Durch Umformung entlang der Umformlinien U1 und U2, die sich schaftlängsaxial erstrecken, werden die drei Schenkel 14, 15, 16 gebildet. Der zweite Schenkel 15 und der dritte Schenkel 16 nehmen den ersten Schenkel 14 zwischen sich auf. Dabei sind der zweite Schenkel 15 und der dritte Schenkel 16 an ihrem dem Federarm 13 zugewandten Ende gegenüber dem ersten Schenkel 14 verkürzt ausgeführt. Die Umformung zum Erhalt des zweiten Schenkels 15 und des dritten Schenkels 16 ist dabei richtungsgleich, wobei beide Schenkel mit ihren freien, schaftlängsaxial gerichteten Außenkanten zueinander gerichtet werden.

Der Schaftkopf 12 bzw. dessen drei Flügel 17, 18, 19 werden erhalten, indem der Stanzling zwei Einschnitte S1 und S2 erhält. Diese werden an dem Federarm 13 abgewandten Ende des Stanzlings 22 entlang der Umformlinien U1 und U2 eingebracht. Die Tiefe der Einschnitte S1 und S2 übersteigt dabei die Flügellänge. Anschließend sind die Flügel 17, 18, 19 entlang der Umformlinie U4 umzuformen, bis sie in etwa quer zur Schaftlängsachse L gerichtet sind und von dieser wegweisen. Die Umformlinie U4 ist etwa quer zur Schaftlängsachse L gerichtet.

Der Federarm 13 wird erhalten, indem der gegenüber den Schenkeln 15 und 16 verlängerte Abschnitt des ersten Schenkels 14 entlang der Umformlinie U3 umgebogen wird, bis dieser Abschnitt entgegen einer Einsetzrichtung X des Befestigungselementes 10 gerichtet ist. Dabei wird der Federarm 13 in Richtung der freien Längskanten des zweiten und dritten Schenkels 15, 16 gerichtet. Die unteren Schmalseiten 23 der kürzeren Schenkel 15 und 16 bilden eine Anschlagfläche für den Federarm 13 aus, die den Endpunkt einer federrückstellelastischen Ausweichbewegung des Federarms 13 beim Einsetzen des Befestigungselementes 10 in die Ausnehmung eines Leuchtenbauteils 25 bilden und so vor einer plastischen Verformung des Federarmes 13 schützten.

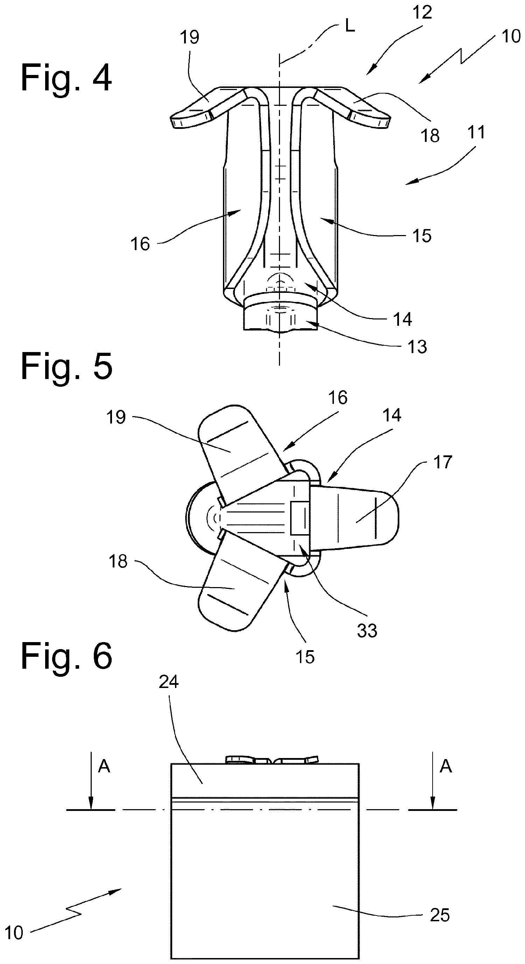

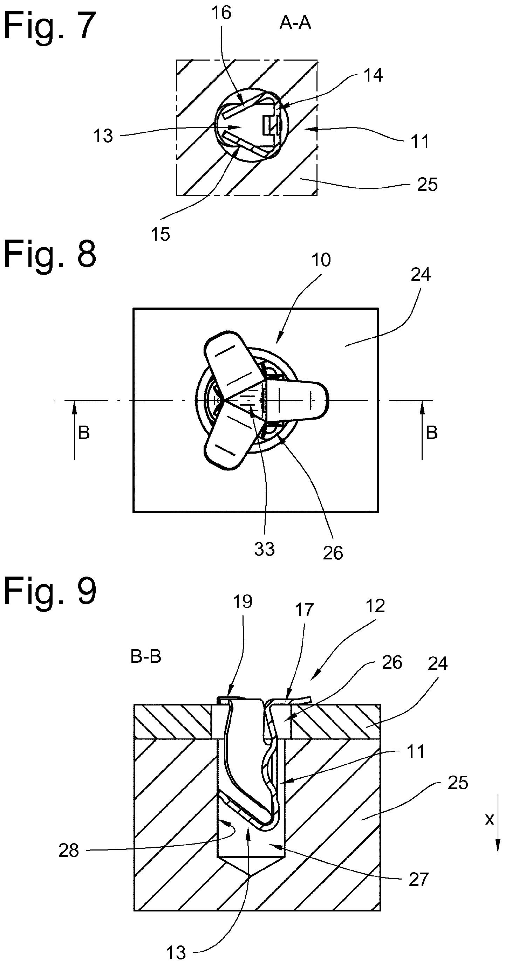

Anhand der Figuren 6 bis 9 wird nunmehr die Funktionsweise des erfindungsgemäßen Befestigungselementes 10 näher erläutert. Die Figuren 6 und 8 zeigen die Montagesituation des Befestigungselementes 10 in Seitenansicht und in Ansicht von oben. Das Befestigungselement 10 hält in den vorgenannten Darstellungen eine Leiterplatte 24 auf einem Leuchtenbauteil 25. Wie insbesondere aus Fig. 8 und 9 ersichtlich ist, weist die Leiterplatte 24 eine Durchbrechung 26 auf, die mit einer leuchtenbauteilseitigen Ausnehmung 27 - hier als Sackloch ausgestaltet - fluchtend angeordnet ist. Die Leiterplatte 24 liegt hierbei auf der Oberseite des Leuchtenbauteils 25 auf. Das Befestigungselement 10 wurde mit dem Federarm 13 voran in Einsetzrichtung x zunächst durch die Durchbrechung 26 hindurchgeführt und in die sacklochartige Ausnehmung 27 eingeschoben. Dabei trifft der Federarm 13 auf die Wandung 28 der Ausnehmung 27 und wird von dieser federrückstellelastisch in Richtung des ersten Schaftschenkels 14 ausgelenkt. Hierbei entsteht eine dieser Auslenkung entgegen gerichtete Federkraft, die den Federarm 13 gegen die Wandung 28 presst und auf diese Weise eine reibschlüssige Verbindung zwischen dem Befestigungselement 10 und der Ausnehmung 27 herstellt. Dieser Reibschluss hält das Befestigungselement 10 gegen Bewegungen entgegen der Einsetzrichtung x. Eine Rastverbindung ist denkbar, wenn die Ausnehmung 27 mit einer Innenumfangsnut oder einem eingeschnittenen Gewinde versehen ist.

Der in seinem Durchmesser gegenüber dem Durchmesser von Durchbrechung 26 und Ausnehmung 27 größere Schaftkopf 12 liegt auf der Leiterplattenoberseite auf. Er hält auf diese Weise die Leiterplatte 24 auf dem Leuchtenbauteil 25 fest.

Der Schaftkopf 11 stellt hier das Spannelement dar. Im Detail bilden dessen Flügel 17, 18, 19 jeweils einen Spannschenkel. Diese werden beim Einsetzen des Befestigungselementes 10 in die Ausnehmung 27 gegen die Leiterplatte 24 gedrückt. Hierbei werden die Flügel17, 18, 19 aus ihrer zur Leiterplatte 24 geneigten Ruhelage entgegen der Einsetzrichtung X federrückstellelastisch ausgelenkt. Sie bringen eine der Einsetzrichtung x entgegen gerichtete Kraft auf die Leiterplatte 24 auf und verspannen diese - der Federschenkel 13 dient als Widerlager - definiert gegen das Leuchtenbauteil 25. Dies ist insoweit vorteilhaft, als über die definierte Andruckkraft zwischen Leiterplatte 24 und Leuchtenbauteil 25 ein definierter Wärmeübergang erreicht werden kann, der für eine entsprechende Wärmeabfuhr von der Leiterplatte 24 und somit von den hier nicht dargestellten LEDs auf das Leuchtenbauteil 25, welches als Kühlkörper dient, erfolgt.

Anhand der Fig. 7, welche eine Schnittdarstellung gemäß Schnittlinie A-A in Fig. 6 darstellt, ist ersichtlich, dass die Schaftschenkel 14, 15, 16 durch ihre Anordnung zueinander dem Schaft eine in etwa dreieckige Querschnittskontur geben, wenn man die Flügeltiefe gedanklich so weit verlängert, dass die freien und schaftlängsachsparallelen Kanten des zweiten und dritten Schaftflügels 15, 16 aneinander anliegen. Alternativ kann man hier auch von einer in etwa trapezförmigen Querschnittskontur sprechen, wenn man in der vorliegenden Darstellung gemäß Fig. 7 die freien und schaftlängsachsparallelen Kanten des zweiten und dritten Schaftflügels 15, 16 über eine Gerade miteinander verbindet.

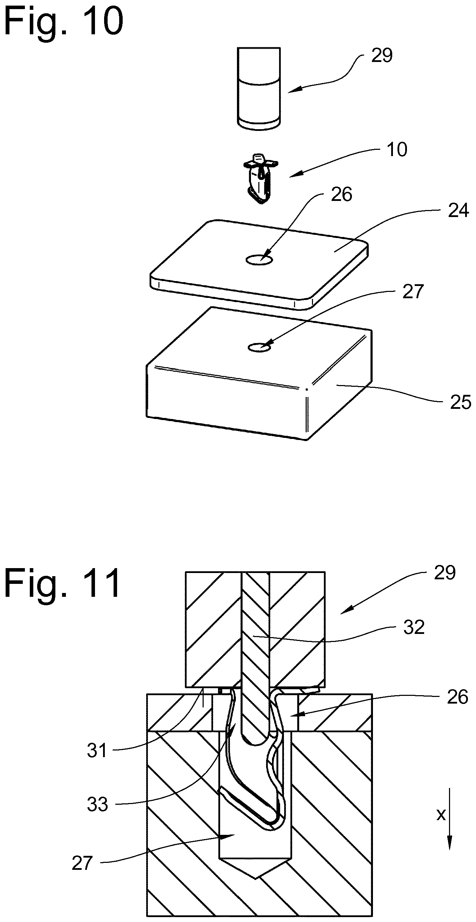

Anhand der Figuren 10 bis 13 wird sowohl der Montagevorgang mit Hilfe eines Montagewerkzeuges 29 als auch der Demontagevorgang mit Hilfe eines Demontagewerkzeuges 30 des Befestigungselementes 10 erläutert.

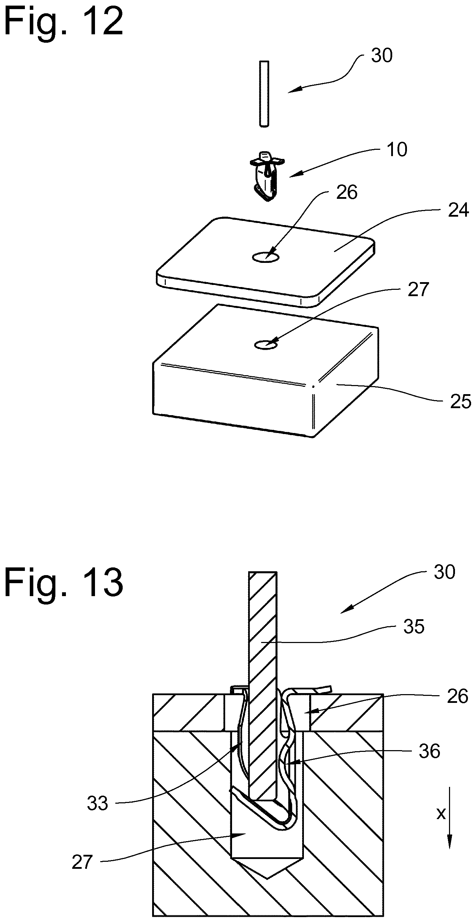

Die Figuren 10 und 12 stellen die Explosionsansicht der Montagesituation und Demontagesituation des Befestigungselementes 10 dar. Die Figuren 11 und 13 entsprechen im Wesentlichen der Schnittansicht gemäß Fig. 9, zeigen jedoch ergänzend ein Montagewerkzeug 29 bzw. ein Demontagewerkzeug 30.

Das Montagewerkzeug 29 gemäß den Figuren 10 und 11 ist als ein Stempel ausgebildet, dessen der Platine zugewandte Wirkfläche 31 eine Vertiefung zur Aufnahme des Schaftkopfes 12 aufweisen. Der Wirkfläche 31 entspringt ein schaftlängsachsparalleler Zentrierdorn 32, der in eine schaftkopfseitige Zentrieröffnung 33 eingreift (siehe Fig. 5, 8, 11). Die Wirkfläche 31 kann magnetisiert sein, um den Schaftkopf im Montagewerkzeug 29 zu halten. Ebenso ist es denkbar, dass der Zentrierdorn 32 reibschlüssig in der Zentrieröffnung 33 gehalten ist und so das Befestigungselement 10 am Montagewerkzeug 29 hält.

Zur Montage des Befestigungsmittels 10 wird nunmehr das Befestigungsmittel 10 an die Wirkfläche 31 des Montagewerkzeuges 29 angesetzt und mit dem Schaft 11 voran durch die Durchbrechung 26 der Leiterplatte 24 in die Ausnehmung 27 des Leuchtenbauteils 25 eingebracht. Die zur Oberfläche der Leiterplatte 24 geneigten Flügel 17, 18, 19 des Schaftkopfes 11 treffen auf die Oberseite der Leiterplatte auf und werden unter Aufbau einer Federrückstellkraft ausgelenkt. Der Federarm hält nach Abschluss der Einsetzbewegung das Befestigungselement 10 in der Ausnehmung 27 gegen die Federrückstellkraft der Flügel 17, 18, 19. Die Federrückstellkraft verspannt so die Bauteile 24 und 25 gegeneinander.

Eine Ausführungsform sieht vor, dass lediglich die Schaftflügel 17, 18, 19 die Federrückstellkraft aufbauen, indem sie entgegen der Einsetzrichtung X bis etwa in eine waagerechte, zur Oberseite der Leiterplatte 24 parallele Position ausgelenkt werden. Sind aber wie im gezeigten Ausführungsbeispiel - Einschnitte S1 und S2 tiefer als die Länge der Flügel 17, 18, 19, so trennen sie schaftkopfnahe Abschnitte der Schenkel 14, 15 16 voneinander. Diese Schenkelabschnitte sind ebenfalls federrückstellelastisch auslenkbar, und zwar in Richtung Schaftlängsachse L. Beim Einsetzen des Befestigungselementes 10 in die Ausnehmung 27 werden die Schenkelabschnitte von den jeweiligen Flügeln 17, 18, 19 und der auf diese wirkende Einsetzkraft in Richtung Schaftlängsachse L verschoben. Die hierbei aufgebrachte Federrückstellkraft der Schenkelabschnitte wirkt über die Flügel 17, 18, 19 verspannend auf die Bauteile 24 und 25. Ein jeweiliger Flügel 17, 18, 19 bildet mit dem zugeordneten Schenkelabschnitt jeweils einen Spannschenkel.

Nach Entnahme des Montagewerkzeuges 29 ist der Montagevorgang abgeschlossen.
Auch für die Demontage des Befestigungsmittels 10 ist ein Werkzeug vorgesehen. Diese trägt die Bezugsziffer 30 und weist einen Lösedorn 35 auf, der zur Demontage des Befestigungsmittels 10 durch dessen Zentrieröffnung 33 hindurch in den Aufnahmeraum 27 hinein gedrückt wird. Dabei trifft dieser Lösedorn 35 auf den Federarm 13 und drückt diesen unter plastischer Verformung in Einsetzrichtung x aus seiner Verankerungsstellung heraus. Hierdurch wird der Reibschluss zwischen dem Federarm 13 und der Wandung 28 der Ausnehmung 27 gelöst und das Befestigungsmittel 10 lässt sich aus der Ausnehmung 27 entnehmen. Dies geschieht in bevorzugter Weise ebenfalls mittels des Demontagewerkzeuges 30, indem beim Einsetzen des Lösedorns 35 durch die Zentrieröffnung 33 in einen Schaftinnenraum eine Reibschlussverbindung zwischen den Schaftschenkeln 14, 15 und 16 und der Außenoberfläche des Lösedorns 35 eingegangen wird. Auf diese Weise folgt das Befestigungselement 10 dem Lösedorn 35 bei dessen Entnahme aus der Ausnehmung 27.

Augenmerk ist noch auf die Führungsprägung 36 des ersten Schenkels 14 zu legen (Fig. 13). Diese drängt den Lösedorn 35 auf das freie Ende des Federarms 13 zu, so dass der Lösedorn 35 dieses in Einsetzrichtung x verformt. Die Führungsprägung 36 verhindert so, dass der Lösedorn 35 auf den Federarm 13 in Richtung dessen Umformbereich rutscht, wodurch die Gefahr bestünde, statt einer lösenden Umformung des Federarmes 13 den Schaft 11 tiefer in die Ausnehmung 27 zu pressen.

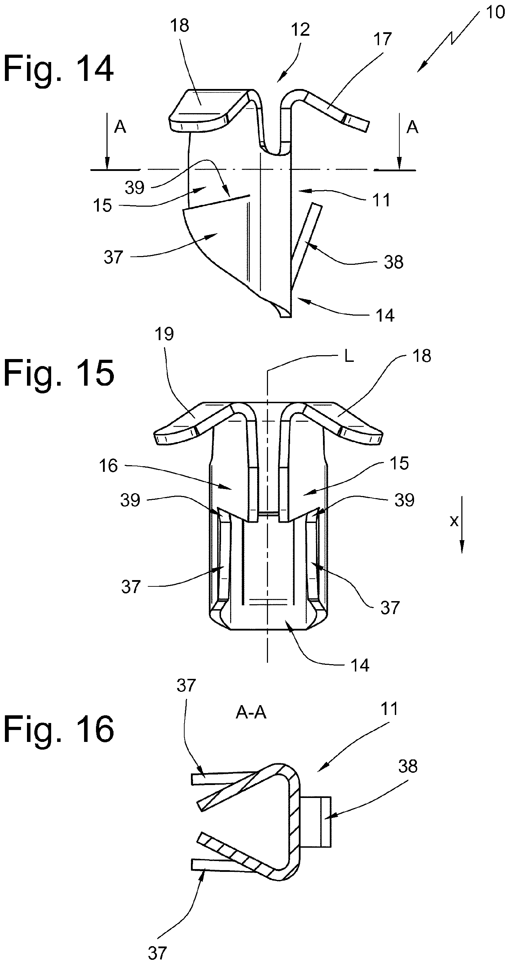

In den Figuren 14 bis 18 ist eine zweite Ausführungsform der Erfindung dargestellt. Das dortige Befestigungselement 10 gleicht weitestgehend dem Befestigungselement 10 der ersten Ausführungsform, weshalb für analoge Bauelemente identische Bezugszeichen verwendet werden und auf die vorangehende Beschreibung Bezug genommen wird. Im Folgenden wird vornehmlich auf die Unterschiede zwischen beiden Ausführungsformen eingegangen.

Das Befestigungsmittel 10 der zweiten Ausführungsform ist ebenfalls aus einem Stanzling geformt, weist einen Schaft 11 mit Schaftkopf 12 auf, wobei Schaft 11 und Schaftkopf 12 entsprechend der ersten Ausführungsform gebildet sind. Insbesondere umfasst der Schaft 11 drei Schaftschenkel 14, 15 und 16 und der Schaftkopf 12 wird von drei Flügeln 17, 18 und 19 gebildet. Auch bei dieser Ausführungsform dient der Schaftkopf 12 mit seinen Flügeln 17, 18 und 19 sowie im Zweifel unter Rückgriff auf voneinander über Einschnitte S1 und S2 voneinander getrennte Schaftschenkelabschnitte als Spannelement. Auch ist, wie insbesondere Figur 16 zu entnehmen ist, der Schaft 11 im Wesentlichen nach Form eines Dreiecks bzw. Trapezes geformt, wodurch seine Stabilität erheblich verbessert ist.

Der wesentliche Unterschied zwischen den beiden Ausführunsformen besteht in den Halteteilen des zweiten Ausführungsbeispiels. Das erste Ausführungsbeispiel ist insbesondere zur Festlegung in einem Sackloch eines Leuchtenbauteils 25 vorgesehen und weist deshalb lediglich einen Federarm 13 auf, der vornehmlich für eine reibschlüssige Verbindung im Sackloch sorgt.

Das Befestigungselement 10 gemäß den Figuren 14 bis 18 ist hingegen dafür vorgesehen, rastbefestigt zu werden. Hierzu trägt wenigstens einer der Schaftschenkel 14, 15 und 16 ein Rastelement 37, 38. Im vorliegenden Ausführungsbeispiel tragen die Schaftschenkel 15 und 16 je einen Rastarm 37, der Schaftschenkel 14 trägt eine Rastfeder 38. Diese Rastelemente 37, 38 sind gegenüber den Schaftschenkeln 14, 15 und 16 umfangserweiternd ausgestellt und werden beim Eintauchen in die Durchbrechung 26 in Richtung Schaftlängsachse L federrückstellelastisch aus ihrer Ruhelage ausgelenkt. Gleiches geschieht, wenn die Rastelemente 37, 38 in den Bereich in den Bereich der Ausnehmung 27 des Leuchtenbauteils 25 eintauchen.

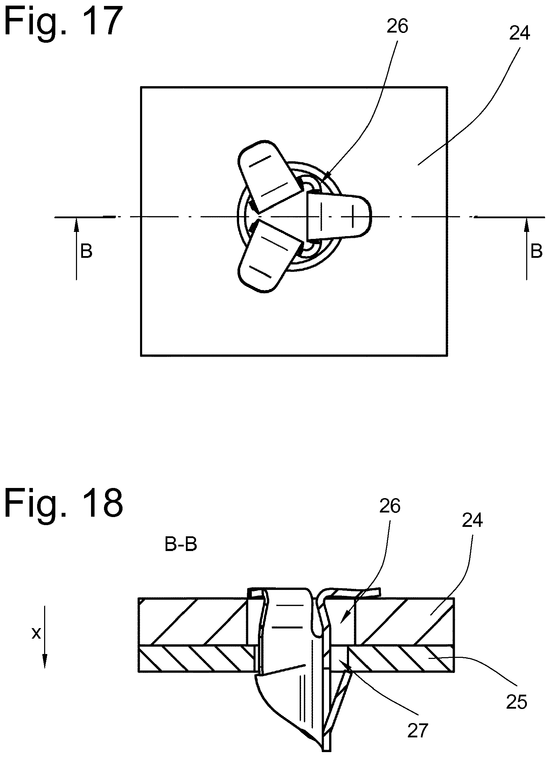

Auch die Ausnehmung 27 des Leuchtenbauteils 25 ist im zweiten Ausführungsbeispiel als Durchbrechung ausgebildet, so dass der dem Schaftkopf 12 abgewandte Endabschnitt des Schaftes 11 nicht nur die Durchbrechung 26 der Leiterplatte sondern auch die Ausnehmung des Leuchtenbauteils 25 durchtauchen kann. Bei diesem Einsetzvorgang in Einsetzrichtung X erfahren die den Schaftkopf bildenden Flügel 17, 18 und 19 und /oder die voneinander durch die Einschnitte S1 und 2 voneinander getrennten Schaftschenkelabschnitte eine federelastische Auslenkung und bauen so die Spannkräfte auf, die den definierten Anpressdruck zwischen Leiterplatte 24 und Leuchtenbauteil 25 erzeugen. Der Einsetzvorgang in Einsetzrichtung erfolgt solange, bis die Rastarme 37 und die Rastfeder 38 durch die Ausnehmung 27 hindurchgelangt sind und sich in ihre Ruhelage zurückbewegen. In dieser hinter bzw. untergreifen sie die Unterseite des Leuchtenbauteils 25 und legen so die Bauteile 24 und 25 aneinander fest. Dies ist insbesondere der Figur 18 zu entnehmen.

Herauszustellen ist, dass das zweite Ausführungsbeispiel lediglich eine alternative Festlegung des Befestigungselementes 10 in der Ausnehmung 27 darstellt, die Funktion und Ausbildung des Spannelementes durch die Flügel 17, 18 und 19 des Schaftkopfes 12 und/oder die voneinander getrennten Schaftschenkelabschnitte identisch zum ersten Ausführungsbeispiel ausgebildet sind.

Die Schräge 39 an den Rastarmen 37 kann dazu dienen gewisse Toleranzen in der Gesamtdicke der Bauteile 24 und 25 auszugleichen ohne dass die durch die Flügel 17, 18, 19 erzeugte Spannfunktion wesentlich beeinflusst wird. Speziell bei der üblichen Verwendung mehrerer Befestigungselemente 10 ist die Gleichmäßigkeit der einzelnen Spannkräfte ein wichtiges Merkmal für einen flächigen Anpressdruck.

### Bezugszeichenliste:

- 10: Befestigungselement
- 11: Schaft
- 12: Schaftkopf
- 13: Federarm
- 14: erster Schenkel
- 15: zweiter Schenkel
- 16: dritter Schenkel
- 17: erster Flügel
- 18: zweiter Flügel
- 19: dritter Flügel
- 20: Isolierkörper
- 21: Lochung
- 22: Stanzling
- 23: Schmalseiten
- 24: Leiterplatte
- 25: Leuchtenbauteil
- 26: Durchbrechung
- 27: Ausnehmung
- 28: Wandung
- 29: Montagewerkzeug
- 30: Demontagewerkzeug
- 31: Wirkfläche
- 32: Zentrierdorn
- 33: Zentrieröffnung
- 35: Lösedorn
- 36: Führungsprägung
- 37: Rastarm
- 38: Rastfeder
- 39: Schräge von 37
- L: Schaftlängsachse
- U1: Umformlinie 1
- U2: Umformlinie 2
- U3: Umformlinie 3
- U4: Umformlinie 4
- S1: Einschnitt 1
- S2: Einschnitt 2
- x: Einsetzrichtung

## Patentansprüche

1. Befestigungselement (10) zur Festlegung eines ersten Bauteils, wie mit LEDs bestückte Leiterplatte (24), welches eine Durchbrechung (26) aufweist mit einem zweiten Bauteil, wie Leuchtenbauteil (25), welches eine Ausnehmung (27), wie Sackloch oder Durchbrechung, aufweist,
- mit einem Schaft (11), der wenigstens ein federrückstellelastisches Halteteil aufweist, um das Befestigungselement (10) am zweiten Bauteil (25) zu verankern,
- mit einem Schaftkopf (12), der gegenüber dem Schaftdurchmesser einen erweiterten Kopfdurchmesser aufweist, wobei
- der Schaftkopf (12) an einem Ende des Schaftes (11) angeordnet ist und
- mit einem Spannelement, um das erste Bauteil (10) gegen das zweite Bauteil (25) unter einer definierten Anpresskraft zu verspannen,
- wobei das Spannelement von zumindest einem federrückstellelastisch auslenkbaren Spannschenkel gebildet ist, der Teil des Schaftkopfes (12) ist und zur Auflage auf dem ersten Bauteil vorgesehen ist, **dadurch gekennzeichnet,**
- **dass** der Schaft (11) von drei untereinander einstückig-stoffschlüssig verbundenen Schenkeln (14, 15, 16) gebildet ist,
- **dass** der Schaftkopf von drei Flügeln (17, 18, 19) gebildet ist, wobei jeder Schenkel (14, 15, 16) je einen Flügel (17, 18, 19) des Schaftkopfes (12) ausbildet, wobei
- die Schenkel (14, 15, 16) durch Umformen eines Stanzlings aus metallischem Blech entlang zweier schaftlängsaxialer Umformlinien (U1, U2) und die Flügel (17, 18, 19) durch die Länge der Flügel (17, 18, 19) übersteigende Einschnitte (S1, S2) entlang der Umformlinien (U1, U2) und anschließendes Umformen entlang einer quer zur Schaftlängsachse gerichteten Umformlinie (U4) erhalten sind,
- und **dass** die Einschnitte (S1, S2) Schenkelabschnitte der Schenkel (14, 15) im Bereich des Schaftes (11) voneinander trennen, die federrückstellelastisch zur Schaftlängsachse auslenkbar sind.

2. Befestigungselement nach Anspruch 1, **dadurch gekennzeichnet, dass** die Flügel (17, 18, 19) jeweils einen Spannschenkel bilden und der Spannschenkel als Teil des Schaftkopfes (11), ausgehend von einer Schaftlängsachse, zur Oberfläche des ersten Bauteils (24) hin abfallend geneigt ist, wobei beim Einsetzen des Befestigungselementes (10) in die Ausnehmung dem Spannschenkel durch Auflaufen auf die Oberfläche des ersten Bauteils (24) eine die Federrückstellkraft aufbauende Bewegung aufgezwungen wird.

3. Befestigungselement nach Anspruch 1, **dadurch gekennzeichnet, dass** die Schenkel (14, 15) in ihrer Länge differieren und das dem Schaftkopf (11) abgewandte, freie Ende eines ersten, längeren Schenkels (14) das Halteteil in Form eines Federarmes (13) bildet.

4. Befestigungselement nach Anspruch 3, **dadurch gekennzeichnet, dass** das freie Ende des ersten, längeren Schenkels (14) durch Umformung wenigstens quer zu, bevorzugt jedoch gegen eine Einsetzrichtung x des Schaftes (11) gerichtet ist.

5. Befestigungselement nach Anspruch 3, **dadurch gekennzeichnet, dass** das freie, dem Schaftkopf (12) abgewandte Ende eines zweiten, kürzeren Schenkels (15) eine Anschlagfläche für den Federarm (13) des ersten Schenkels (14) ausbildet.

## Claims

1. Fastening element (10) for securing a first component, such as a circuit board (24) equipped with LEDs, having a through-hole (26), to a second component, such as a lamp component (25), having a recess (27), such as a blind hole or through-hole,
- having a shaft (11) which has at least one spring-return retaining part for anchoring the fastening element (10) on the second component (25),
- having a shaft head (12) which has a head diameter that is wider than the shaft diameter, wherein
- the shaft head (12) is arranged at one end of the shaft (11), and
- having a clamping element for clamping the first component (10) against the second component (25) under a defined pressing force,
- wherein the clamping element is formed by at least one deflectable spring-return clamping limb which is part of the shaft head (12) and is provided to bear against the first component,
**characterized**
- **in that** the shaft (11) is formed of three limbs (14, 15, 16) which are materially connected in one piece with one another,
- **in that** the shaft head is formed of three vanes (17, 18, 19), wherein each limb (14, 15, 16) forms a respective vane (17, 18, 19) of the shaft head, wherein
- the limbs (14, 15, 16) are obtained by forming a blank made of sheet metal along two forming lines (U1, U2) parallel to the shaft longitudinal axis, and the vanes (17, 18, 19) are obtained by making incisions (S1, S2) along the forming lines (U1, U2), said incisions exceeding the length of the vanes (17, 18, 19), and then forming along a forming line (U4) which is oriented transversely to the shaft longitudinal axis,
- and **in that** the incisions (S1, S2) separate limb sections of the limbs (14, 15) from one another in the region of the shaft (11), which limb sections can be deflected relative to the shaft longitudinal axis with spring return.

2. Fastening element according to claim 1, **characterized in that** the vanes (17, 18, 19) each form a clamping limb, and the clamping limb, as part of the shaft head (11), is inclined downwards from a shaft longitudinal axis to the surface of the first component (24), wherein, as the fastening element (10) is inserted in the recess, a movement which builds up the spring return force is imposed on the clamping limb as the latter runs up onto the surface of the first component (24).

3. Fastening element according to claim 1, **characterized in that** the limbs (14, 15) differ in length, and the free end of a first, longer limb (14), remote from the shaft head (11), forms the retaining part in the form of a spring arm (13) .

4. Fastening element according to claim 3, **characterized in that**, as a result of the forming, the free end of the first, longer limb (14) is oriented at least transversely to, but preferably counter to, a direction of insertion x of the shaft (11).

5. Fastening element according to claim 3, **characterized in that** the free end of a second, shorter limb (15), remote from the shaft head (12), forms a stop surface for the spring arm (13) of the first limb (14).

## Revendications

1. Elément de fixation (10) servant à fixer un premier composant, par exemple une carte de circuits imprimés (24) équipée de LED qui possède un trou débouchant (26), avec un deuxième composant tel qu'un composant lumineux (25) qui possède un évidement (27) tel qu'un trou borgne ou un trou débouchant,
- avec une tige (11) qui comporte au moins un élément de retenue élastique à ressort de rappel pour ancrer l'élément de fixation (10) au niveau du deuxième composant (25),
- avec une tête de tige (12) dont le diamètre de la tête est supérieur au diamètre de la tige,
- la tête de tige (12) étant disposée à une extrémité de la tige (11), et,
- avec un élément de serrage pour pré-contraindre le premier composant (24) contre le deuxième composant (25) avec une force de pression définie,
- l'élément de serrage étant formé par au moins une branche de serrage qui peut être déviée élastiquement par un ressort de rappel, qui est partie de la tête de tige (12) et prévue afin de s'appuyer sur le premier composant,
**caractérisé en ce que**
- la tige (11) est formée d'au moins trois branches (14, 15, 16) reliées ensemble en une pièce à liaison de forme,
- la tête de la tige est formée de trois ailes (17, 18, 19), chaque branche (14, 15, 16) réalisant respectivement une aile (17, 18, 19) de la tête de tige (12),
- les branches (14, 15, 16) étant obtenues par déformation d'une baguette en tôle métallique le long de deux lignes de formage (U1, U2) axiales longitudinalement à la tige, et les ailes (17, 18, 19) à travers les longueurs des découpes (S1, S2) montant sur les ailes (17, 18, 19), le long des lignes de formage (U1, U2) et par déformation consécutive, le long d'une ligne de déformation (U4) dirigée transversalement à l'axe longitudinal de tige,
- et **en ce que** les découpes (S1, S2) séparent les sections de branche des branches (14, 15) dans la zone de la tige (11) qui peuvent être déviées élastiquement par un ressort de rappel, par rapport à l'axe longitudinal de la tige.

2. Elément de fixation selon la revendication 1, **caractérisé en ce que** les ailes (17, 18, 19) forment respectivement une branche de serrage et **en ce que** la branche de serrage est inclinée vers le bas, en tant que partie de la tête de tige (12), en partant d'un axe longitudinal de la tige, en direction de la surface du premier composant (24), un mouvement créant la force de rappel élastique étant imposé, lors de la mise en place de l'élément de fixation (10) dans l'évidement, à la branche de serrage par contact sur la surface du premier composant (24).

3. Elément de fixation selon la revendication 1, **caractérisé en ce que** les branches (14, 15) sont différentes au niveau de leur longueur et que l'extrémité libre, détournée de la tête de tige (12), d'une première branche (14) plus longue forme l'élément de retenue en forme de bras ressort (13).

4. Elément de fixation selon la revendication 3, **caractérisé en ce que** l'extrémité libre, de la première branche (14) plus longue, est dirigée par déformation au moins transversalement, cependant de manière préférentielle, à l'opposé d'une direction de mise en place x de la tige (11).

5. Elément de fixation selon la revendication 3, **caractérisé en ce que** l'extrémité libre, détournée de la tête de tige (12), d'une deuxième branche (15) plus courte forme une face de butée pour le bras ressort (13) de la première branche (14).
